Europäisches Patentamt

European Patent Office

Office européen des brevets

(11) Publication number: 0 337 657
A2

## (12) EUROPEAN PATENT APPLICATION

(21) Application number: 89303380.3

(22) Date of filing: 05.04.89

(51) Int. Cl.4: H01L 39/24 , H01L 39/02

(30) Priority: 12.04.88 GB 8808619

(43) Date of publication of application:
18.10.89 Bulletin 89/42

(84) Designated Contracting States:
AT BE CH DE ES FR GB IT LI LU NL SE

(71) Applicant: IMPERIAL CHEMICAL INDUSTRIES PLC
Imperial Chemical House Millbank
London SW1P 3JF(GB)

(72) Inventor: Alford, Neil McNeil
49a Daleside
Upton-by-Chester Chester(GB)

(74) Representative: Walmsley, David Arthur Gregson et al
Imperial Chemical Industries PLC Legal department: Patents PO Box 6 Bessemer Road
Welwyn Garden City Hertfordshire AL7 1HD(GB)

(54) Superconducting article.

(57) An article having superconducting properties which comprises a first structure of a ceramic superconducting material and a second structure bonded to the first structure by means of an adhesive, in which one or both of the adhesive and the second structure are electrically conducting. The first structure may comprise sintered particles of a superconducting oxide having a critical temperature not lower than liquid nitrogen temperature, and the second structure may be a metal or alloy.

EP 0 337 657 A2

## SUPERCONDUCTING ARTICLE

This invention relates to an electrically superconducting shaped article, e.g. to a wire or rod, and in particular to an article which is not only electrically superconducting at low temperature but which is also electrically conducting at normal temperatures. The invention relates to an article in the form of a composite structure which possesses the aforementioned properties.

The phenomenon of electrical superconductivity has been known for many years but until recently such superconductivity could only be attained at extremely low temperatures, for example in a niobium alloy, e.g. in a niobium-tin alloy.

The temperatures at which electrical superconductivity in such alloys can be attained are generally below $23°K$ and such temperatures can be obtained only by using liquid helium as a coolant. Such extremely low temperatures, and the expense of liquid helium as a coolant, have limited the practical application of the phenomenon of superconductivity. Nevertheless, superconducting materials are used in commercial practice, such as in nuclear magnetic research scanners.

Although superconducting materials are used in commercial practice failure of the cooling system in a commercial installation, and a consequent rise in temperature to a temperature above the so-called critical temperature at which the material is no longer electrically superconducting, may have serious consequences for the equipment in which the superconducting material is installed.

In order to avoid or at least mitigate such consequences it is necessary to ensure that, at a temperature above this so-called critical temperature at which the material is no longer electrically superconducting, the material at least remains electrically conducting and capable of conducting a reasonable electrical current. If the superconducting material is not even able to conduct a reasonable electrical current at a temperature above the critical temperature there may be particularly serious consequences for the equipment in which the superconducting material is installed.

Even where the superconducting material is a metallic alloy such as a niobium-tin alloy, which is at least electrically conducting at a temperature above the critical temperature, the material may for example be of very small cross-section such that its current carrying capacity at a temperature above the critical temperature may also be small, and in particular the current carrying capacity at this latter temperature may not be as great as may be necessary.

This problem of small current carrying capacity in known metallic alloy superconducting materials at a temperature above the critical temperature has been solved by making a composite structure comprising a copper component and an electrically superconducting component. For example, it is known to make a composite wire by inserting a rod of niobium alloy superconducting material into a core drilled in a billet of copper and drawing down the billet to form a composite wire having a copper outer sheath and a core of a superconducting material. The billet may comprise a plurality of cores into each of which a rod of superconducting material is inserted. The current carrying capacity of the copper sheath at a temperature above the critical temperature is much greater than that of the core or cores of super-conducting material alone and the problem referred to above is avoided.

In a more recent development the phenomenon of electrical superconductivity has been observed in certain materials at substantially higher temperatures than those which are attainable only by cooling with liquid helium. In particular the phenomenon of superconductivity has been observed at temperatures which may be as high as $77°K$, or even higher, that is at temperatures which are attainable by cooling with liquid nitrogen. The fact that superconductivity is attainable at such relatively high temperatures, and the fact that the required coolant is the relatively inexpensive liquid nitrogen, has opened up the possibility of much more widespread practical applications of the phenomenon of superconductivity than have been possible hitherto.

The materials which exhibit electrical superconductivity at such relatively high temperatures, which may be as high as $77°K$ or higher, are ceramic materials which are relatively easy to make and which are relatively inexpensive. For example, in Z. Phys. B. - Condensed Matter, 64, pp 189-193 (1986) J. G. Bednorz and K. A. Muller reported the preparation of coprecipitated and heat treated mixtures of lanthanum, barium, copper and oxygen and they reported that the mixtures showed superconductivity at a critical temperature higher than the critical temperatures which had been observed hitherto for metals and alloys. The mixtures were reported to have a composition $La_{5-x}Ba_xCu_5O_{5(3-y)}$ where $x = 0.75$ to 1 and compositions were prepared by coprecipitation from barium-, lanthanum- and copper nitrate solutions by addition to an oxalic acid solution followed by decomposition and solid state reaction at $900°C$ for 5 hours and sintering in an oxygen atmosphere.

In published European Patent Application 0 275 343 there is described a superconductive compound having a critical temperature above $28°K$,

and which may be as high as 35°K. The compound is of the $RE_2TMO_4$ type wherein the rare earth element (RE) is partially substituted by one or more alkaline earth metal elements (AE) and wherein the oxygen contents is adjusted such that the resulting crystal structure is distorted and comprises a phase of the general compositions $RE_{2-x}AE_xTMO_{4-y}$, wherein TM represents a transition metal and $x<0.3$ and $y<0.5$. A favoured rare earth element is lanthanum, a favoured alkaline earth element is barium, and a favoured transition metal is copper.

In International Patent Application No PCT/US 87/02958, International Publication No WO 88/05029, there is described a composition which is superconducting at a temperature of 40°K and higher, and which comprises a sintered metal oxide complex of the formula

$[L_{1-x}M_x]_aA_bO_y$

in which L is yttrium, lanthanum, cerium, preasodymium, neodymium, samarium, europium, gadolinium, terbium, dysprosium, holmium, erbium, thulium, ytterbium, or lutetium, or a combination thereof, M is barium, strontium, calcium, magnesium, mercury, or a combination thereof, provided that when L is lanthanum M is not barium, A is copper, bismuth, tungsten, zirconium, tantalum, niobium, or vanadium, x is from about 0.01 to 1.0, a is 1 to 2, b is 1, and y is about 2 to 4.

In the aforementioned International Publication there is also described the production of the sintered metal oxide complex by heating a mixture of solid compounds containing L, M, A and O in proportions appropriate to yield the aforementioned formula to a temperature of 640-800°C in an oxygen atmosphere and for a time sufficient to react the mixture in the solid state and then heating the mixture at 900-1100°C for a period of at least about 12 hours subsequent to the reaction, pelletizing the mixture, and sintering the pellets. With certain of the sintered metal oxide complexes a critical temperature as high as 100°K, that is -173°C, has been observed. A preferred sintered metal oxide complex is that in which L is yttrium, M is barium, and A is copper and one phase of such a preferred material which has been identified as having a high critical temperature is that having empirical formula $YBa_2Cu_3O_x$ where x is typically between 6.5 and 7.2.

Merely by way of example, and to illustrate the ease of production, the production of such an yttrium-barium-copper oxide ceramic material will be described. A suitable yttrium-barium-copper oxide is that having the composition $YBa_2Cu_3O_x$ where x is between 6.5 and 7.2. Such a ceramic superconducting material may be produced by forming a mixture of the oxides of the required elements, and/or of precursors for these oxides, eg carbonates, in the required proportions, heating the mixture at an elevated temperature in an oxygen-containing atmosphere, eg at a temperature of 900 to 950°C or higher in air, for a time which is of the order of 12 to 24 hours, and subsequently cooling the thus formed ceramic material. The thus formed ceramic superconducting material may be in the form of a sintered structure which, if desired, may be ground in order to convert the material into a particulate form which is suitable for shaping into the form of an antenna.

Articles may be produced from the particulate ceramic material by processes which are conventional in the ceramics processing art, for example, by powder pressing, by isostatic pressing, or by slip casting. For example, the particulate ceramic material may be pressed in a mould into a desired shape at elevated pressure and the material may be heated at elevated temperature in an oxygen-containing atmosphere, e.g. in air at a temperature of the order of 900 to 950°C or higher, in order to sinter together the particles of ceramic material. The thus sintered article may then be cooled slowly to ambient temperature in an oxygen-containing atmosphere, and during the cooling process the article may be annealed, for example at a temperature of approximately 400°C to 450°C. In an alternative process the article may be formed by shaping a composition which comprises the particulate ceramic material and an organic material and the organic material may be removed from the thus shaped article by heating at elevated temperature. Thereafter, the particles of ceramic material may be sintered and the sintered article may be cooled and annealed following the procedure hereinbefore described.

Superconducting ceramic materials of the type described have little or no current carrying capacity at a temperature above the critical temperature and this problem of lack of current carrying capacity at such a temperature is much greater than in the case of metallic alloy superconducting materials. However, although the problem might possibly be solved by means of a composite structure the inventor has realised that, where the superconducting material is a ceramic material, such a composite structure could not be formed by the method hereinbefore described. Thus, although it would be possible to insert a rod or rods of sintered particulate superconducting ceramic material into a core or cores in a billet of copper it would not be possible to draw down the billet and the rod or rods in the manner hereinbefore described as the ceramic material is not ductile in the manner in which a metallic alloy superconducting material is ductile.

The present invention relates to an article which is a composite structure comprising a ceramic electrically superconducting material and an electrically conducting material. The article is electrically superconducting at a temperature below the critical temperature and also is electrically conducting and may be arranged to have a substantial current carrying capacity at a temperature above the critical temperature.

According to the present invention there is provided an article having superconducting properties which comprises a first structure of a ceramic electrically superconducting material and a second structure bonded to the first structure by means of an adhesive, in which one or other or both of the second structure and the adhesive are electrically conducting.

For simplicity the ceramic material of the first structure which is electrically superconducting will hereafter merely be referred to as being superconducting.

In use and at a temperature below the critical temperature electrical current is carried by the first structure of the article which behaves as a superconductor. At a temperature above the critical temperature the first structure no longer behaves as a superconductor and the electrical current is carried by the second structure and/or by the adhesive which is or are electrically conducting at normal temperatures. Furthermore, in the first structure excessive heat may develop at so-called "hot-spots" and the second structure and/or the adhesive serve as thermal conductor(s) through which this heat may be removed from the first structure. If the heat was not removed it is possible that in use the temperature of the first structure may rise to a temperature above the critical temperature.

In the article of the invention the first structure may be in the form of a structure comprising sintered particles of ceramic superconducting material. The second structure may or may not be electrically conducting but it is preferred that it is electrically conducting as it is then possible for the article of the invention to have a greater current carrying capacity at a temperature above the critical temperature of the ceramic superconducting material.

The ceramic superconducting material of the first structure may be any ceramic material which has superconducting properties, and it is preferably one which has a critical temperature, that is becomes superconducting, at a temperature which is not lower than the temperature at which liquid nitrogen boils. Merely by way of example of such materials there may be mentioned ceramic oxides, for example, the rare earth-barium-copper oxides, e.g. the yttrium-barium-copper oxides, the lanthanum-strontium-copper oxides, and the bismuth-calcium-strontium-copper oxides. A suitable yttrium-barium-copper oxide is that having the

composition $YBa_2Cu_3O_x$ where x is between 6.5 and 7.2. Such ceramic superconducting materials may be produced by forming a mixture of the oxides of the required elements, and/or of precursors for these oxides, e.g. carbonates, in the required proportions, heating the mixture at an elevated temperature in an oxygen-containing atmosphere, e.g. at a temperature of 900 to 950°C or higher in air, for a time which is of the order of 12 to 24 hours, and subsequently cooling the thus formed ceramic material. The thus formed ceramic superconducting material may be in the form of a sintered structure which, if desired, may be ground in order to convert the material into a particulate form.

The first structure of the article of the invention may be produced from the particulate ceramic superconducting material, or from precursors therefor, by processes which are conventional in the ceramics processing art, for example, by powder pressing, by isostatic pressing, or by slip casting. For example, the particulate ceramic superconducting material, or precursors therefor, may be pressed in a mould into a desired shape at elevated pressure and heated at elevated temperature in an oxygen-containing atmosphere, e.g. in air at a temperature of the order of 900 to 950°C or higher, in order to sinter together the particles of ceramic material. The thus sintered structure may be cooled slowly to ambient temperature in an oxygen-containing atmosphere, and during the cooling process the structure may be annealed, for example at a temperature of approximately 400°C to 450°C. In an alternative process the structure may be formed by shaping a composition which comprises the particulate ceramic superconducting material, or precursors therefor, and an organic material, for example, by extruding the composition into the form of a rod or by calendering the composition into the form of a sheet or film. Thereafter the organic material may be removed from the thus shaped structure by heating at elevated temperature, the particles of ceramic material may be sintered, or the precursors may be converted to ceramic superconducting material and sintered, and the sintered structure may be cooled following the procedure hereinbefore described. In a preferred process the first structure is formed from a composition comprising particulate ceramic superconducting material, or precursors therefor, a liquid, and an organic material, eg an organic polymeric material, soluble in or dispersible in the liquid. Such a composition is preferred as it may readily be shaped into a variety of shapes for the first structure. The material of the second structure may or may not be electrically conducting but for the reasons hereinbefore referred to it is preferably electrically conducting, and it is preferably a metal of high electrical conductivity. The material, which in the case of a metal may be an alloy of two or more metals, preferably has an electrical conductivity of greater than $10^4$ ohm$^{-1}$ cm$^{-1}$, and more preferably greater than $10^5$ ohm$^{-1}$ cm$^{-1}$. Suitable metals include nickel, aluminium, tungsten, iron, platinum, silver and copper.

The adhesive by means of which the first and second structures of the article of the invention are bonded to each other may or may not be electrically conducting, but it is preferably electrically conducting for the reasons hereinbefore referred to. The adhesive may be an organic material, for example a curable liquid organic material which is capable of being cured to a solid resinous material. For example, the adhesive may be curable epoxy resin. The organic material adhesive may be electrically conducting, for example, it may be filled with metallic particles. However, it is preferred that the adhesive is a metallic material which is itself electrically conducting. The adhesive may be a relatively low melting solder, and such a form of adhesive is particularly suitable where the second structure is itself a metallic material. Metallic materials in the form of a relatively low melting solder and which may be used as the adhesive are well known in the art.

The presence of the adhesive and of the second structure in the article of the invention confers substantial benefits additional to those already referred to. Thus, ceramic superconducting materials, for example, when in the form of a structure comprising sintered particles of ceramic superconducting material, do not have a strength which is as great as may be desired, particularly when in the form of a structure of small cross-section, and the presence of a second structure bonded to the first structure of superconducting ceramic material by means of an adhesive confers a beneficial increase in strength on the first structure.

The article of the invention may have a variety of different shapes, and the invention is not limited to an article having any particular shape. For example, the article may be in the form of a planar article, e.g. in the form of a sheet. To produce such a structure a planar first structure and/or a planar second structure may be contacted with an adhesive and the structures may be brought together with the adhesive sandwiched between the structures. For example, in the case where the second structure is metallic a face of a planar second structure, or of a planar first structure or both, may be coated with liquid organic adhesive or with a metallic solder in liquid form, the coated face(s) may be brought together, and the liquid organic adhesive or the solder caused or allowed to solidify. The structure may be clamped together during the construction and prior to solidification of the liquid organic adhesive or the solder in order to ensure a good bond between the planar surfaces over the whole area thereof.

The article of the invention may be in the form of a wire or rod. For example, a first structure of a ceramic superconducting material in the form or a wire or rod may be coated with an adhesive, for example, by drawing the wire or rod through a bath of liquid organic adhesive or liquid solder and the thus coated wire or rod may then be inserted into the second structure which is in the form of a tube, and the liquid organic adhesive or the solder caused or allowed to solidify. In an alternative manner of construction a first structure in the form of a wire or rod may be inserted into a second structure in the form of a tube, the liquid organic adhesive or liquid solder may be inserted into the annular space between the first and second structures, and the liquid organic adhesive or the solder may be caused or allowed to solidify.

The dimensions of the first and second structures, and thus of the article of the invention, may vary over a considerable range, and they may be varied for a variety of reasons. One factor which will have a bearing on these dimensions is the current carrying capacity which is required in the superconducting first structure at a temperature below the critical temperature, and on the current carrying capacity which is desired in the second structure and/or in the adhesive layer at a temperature above the critical temperature. For simplicity, and by way of example only, it will be assumed that in use the electrical current at a temperature above the critical temperature is carried substantially completely by the second structure and that little or no current is carried by the adhesive.

In general the structures will have a greater cross-sectional area the greater is the current carrying capacity which is desired. Where the article of the invention is in the form of a wire or rod the first structure may have a diameter varying between a few microns and several thousand microns, e.g. from 10 microns to 5000 microns, although these diameters are by way of example only and are not meant to be limiting. Where the article is in the form of a wire or rod the second structure in the form of a tube may likewise have a wall thickness varying between a few microns and several thousand microns, e.g. from 10 microns to 5000 microns. Where the article of the invention is in the form of a planar structure the first and second structures may have thicknesses the same as, respectively, the diameter of the wire or rod of the first structure and the thickness of the walls of the tubular second structure referred to above.

The thickness of the adhesive layer may similarly vary over a wide range but it will generally have a thickness which is sufficient to form an adequate bond between the first and second structures.

The invention will now be described with the aid of the following example.

## EXAMPLE

A particulate mixture of $BaCO_3$, $CuO$, and $Y_2O_3$ in proportions by weight of 52.9:32.0:15.1 was charged to a plastic container together with ethanol and the mixture was mixed and ground on a vibro energy mill using zirconia as a grinding medium. The mixture was removed from the plastic container and dried on a rotary evaporator and then heated in a furnace in an atmosphere of air at a temperature of $900^{\circ}C$ for 12 hours. The mixture was then removed from the furnace and reground using the above-described procedure until the resulting particulate material had a surface area as measured by the BET method in the range 1 to 6 $m^2g^{-1}$. The particulate material had a particle size in the range 0.001 to 5 micrometres and had a composition, as determined by X-ray diffraction, of $YBa_2Cu_3O_x$. Thermogravimetric analysis indicated x had a value of 6.9.

100 parts by weight of the particulate material were mixed with 7 parts by weight of polyvinyl butyral and with 10.5 parts by weight of cyclohexanone, and the viscous composition was passed repeatedly through the nip between the rolls of a twin-roll mill at ambient temperature. The composition which adhered to one of the rolls of the mill was repeatedly removed from the roll, turned at right angles, and passed back through the nip in order to produce a homogeneously mixed composition. During the mixing procedure on the twin-roll mill some of the cyclohexanone evaporated. The sheet which was produced on the twin roll mill was removed from the mill, chopped into small pieces, charged to a ram extruder, and extruded in the form of a 1 mm diameter wire. The wire was then heated in an oven at $80^{\circ}C$ to evaporate the cylcohexanone, then at $450^{\circ}C$ for 60 minutes to burn off the polyvinyl butyral, and finally the wire was heated in an atmosphere of oxygen at $920^{\circ}C$ for 12 hours to sinter the particles of superconducting material and the oven and contents were then cooled to $400^{\circ}C$ in an atmosphere of oxygen at a rate of $1^{\circ}C$ per minute. The temperature of the oven was then held at $400^{\circ}C$ for 10 hours and finally it was cooled to ambient temperature at a rate of $1^{\circ}C$ $min^{-1}$.

The wire of superconducting material was inserted in a copper tube having an internal diameter of 2 mm and an external diameter of 3 mm and molten Woods metal at a temperature of $80^{\circ}C$ was inserted in the annular space between the wire and the tube and allowed to solidify.

The thus produced article was found to be superconducting when cooled in liquid nitrogen and to be electrically conducting at ambient temperature.

## Claims

1. An article having supeconducting properties which comprises a first structure of a ceramic superconducting material and a second structure bonded to the first structure by means of an adhesive, in which one or both of the adhesive and the second structure are electrically conducting.

2. An article as claimed in claim 1 in which the first structure comprises sintered particles of ceramic superconducting material.

3. An article as claimed in claim 1 or claim 2 in which the second structure is electrically conducting.

4. An article as claimed in any one of claims 1 to 3 in which the ceramic superconducting material has a critical temperature which is not lower than the temperature at which liquid nitrogen boils.

5. An article as claimed in any one of claims 1 to 4 in which the ceramic material comprises ceramic oxides.

6. An article as claimed in claim 5 in which the ceramic oxide has a formula $YBa_2 Cu_2 O_x$ where x is between 6.5 and 7.2.

7. An article as claimed in any one of claims 1 to 6 in which the first structure is formed from a composition comprising particulate ceramic superconducting material, a liquid, and an organic polymeric material soluble in or dispersible in the liquid.

8. An article as claimed in any one of claims 1 to 7 in which the second structure is made of a metal or alloy of two or more metals.

9. An article as claimed in any one of claims 1 to 8 has an electrical conductivity of greater than $10^5$ $ohm^{-1}$ $cm^{-1}$.

10. An article as claimed in any one of claims 1 to 9 in which the adhesive is a metallic material which is electrically conducting.

11. An article as claimed in claim 10 in which the adhesive is a low melting solder.

12. An article as claimed in any one of claims 1 to 11 which has a planar shape.

13. An article as claimed in any one of claims 1 to 11 which is in the form of a wire or rod comprising a wire or rod first structure a second structure in the form of a tube.

14. An article as claimed in claim 13 in which the first structure has a diameter in the range 10 to 5000 microns.

15. An article as claimed in claim 13 or claim 14 in which the second structure has a wall thickness of 10 to 5000 microns.